# EUROPÄISCHE PATENTSCHRIFT

(11) **EP 2 806 283 B1**
(45) Veröffentlichungstag und Bekanntmachung des Hinweises auf die Patenterteilung: **29.03.2017**
(21) Anmeldenummer: 14168460.5
(22) Anmeldetag: 15.05.2014
(51) Int. Cl.: G01R 33/07, G01R 33/02, G01R 33/00

(54) **Dreidimensionaler Hallsensor zum Detektieren eines räumlichen Magnetfeldes**
Three-dimensional Hall sensor for detecting a spatial magnetic field
Capteur Hall tridimensionnel destiné à détecter un champ magnétique spatial

(30) Priorität: 22.05.2013 DE 102013209514
(43) Veröffentlichungstag der Anmeldung: 26.11.2014
(73) Patentinhaber: Micronas GmbH, 79108 Freiburg i. Br. (DE)
(72) Erfinder: Paul, Oliver, 79280 Au (DE); Ruther, Patrick, 76199 Karlsruhe (DE); Taimur, Aftab, 79115 Freiburg (DE)
(74) Vertreter: Grünecker Patent- und Rechtsanwälte PartG mbB

(56) Entgegenhaltungen:
- WO-A1-2005/029604
- DE-A1-102009 027 338
- US-A1- 2010 097 059

## Beschreibung

Die vorliegende Erfindung bezieht sich auf einen dreidimensionalen Hallsensor zum Detektieren eines räumlichen Magnetfeldes. Weiterhin bezieht sich die vorliegende Erfindung auf ein Verfahren zum Messen des räumlichen Magnetfeldes mittels dieses Hallsensors. Die Messung eines dreidimensionalen Magnetfeldvektors **B,** d. h. seiner drei Komponenten Bₓ, B_{y} und B_{z} bezüglich eines Koordinatensystems x, y, z, ist von großer technischer Bedeutung.

Hallsensoren werden beispielsweise häufig zur berührungslosen Messung von Bewegungen mittels der magnetischen Wechselwirkung zwischen einem oder mehreren Permanentmagneten und dem Hallsensor eingesetzt. Derartige Messung von Bewegungen und Positionen findet z. B. für die Steuerung von Werkzeugmaschinen, in der Pneumatik, in der Automatisierungstechnik und Robotik sowie im Automobilbereich Anwendung.

Eine berührungslose Erfassung von Bewegungen bietet unter anderem den Vorteil der Verschleißfreiheit. Unter den bekannten berührungslosen Messverfahren sind die optischen und magnetischen Verfahren am weitesten verbreitet. Während die optischen Verfahren aufgrund der kleinen Wellenlänge des Lichts eine sehr hohe Genauigkeit garantieren, sind magnetische Verfahren weit weniger empfindlich gegenüber Verschmutzung und Beschädigung, insbesondere dadurch, dass Magnete und Sensorkomponenten in einer nicht magnetischen hermetischen Hülle vollständig gekapselt werden können.

Von diversen Herstellern werden Weggebersysteme angeboten, bei denen die Position eines verschieblichen Permanentmagneten mit Hilfe eines dreidimensionalen Hallsensors ermittelt wird. Dabei müssen zur Erfassung der linearen Relativbewegungen an einem Ort mindestens zwei, optimal drei, zueinander senkrecht stehende Magnetfeldkomponenten gemessen werden und ihr Quotient wird zur Lageerkennung ausgewertet. Diese Vorgehensweise hat den Vorteil, dass jeweils in Bereichen, in denen eine Feldkomponente einen Extremwert annimmt und daher kleine Verschiebungen nicht detektiert, die andere Feldkomponente auf Verschiebungen um so stärker reagiert, so dass im gesamten Messbereich eine annähernd gleich hohe Messgenauigkeit gegeben ist. Essentiell ist aber, dass alle drei Komponenten Bₓ, B_{y} und B_{z} mit gleicher, d. h. isotroper Sensitivität gemessen werden können.

Eine weit verbreitete Kategorie von Magnetfeldsensoren nutzt den Halleffekt in Halbleitern, insbesondere in Siliziumchips, die mit Verfahren der Halbleitertechnologie gefertigt werden. Aufgrund technologischer Einschränkungen unterscheiden sich Strukturen, welche die zur Chipoberfläche senkrechte Magnetfeldkomponente messen, deutlich von Sensoren, die in der Lage sind, eine in der Chipfläche liegende Komponente zu messen. Im ersten Fall wird zur Messung die sogenannte Hallplatte, ein üblicherweise ausgedehnter dünner n-leitender Bereich an der Oberfläche des Chips mit vier Kontakten an seiner Peripherie, zur Messung verwendet. Eine solche Hallplatte und die theoretischen Grundlagen für die Fertigung derselben sind beispielsweise aus dem Artikel R. S. Popović: "HALL-EFFECT DEVICES", Sensors an Actuators, 17 (1989), Seiten 39 - 53, bekannt. Figur 6 zeigt das in diesem Dokument gezeigte Messprinzip mit einer Hallplatte mit vier Kontakten zu einem n-leitenden Bereich für die Messung der senkrechten Magnetfeldkomponente.

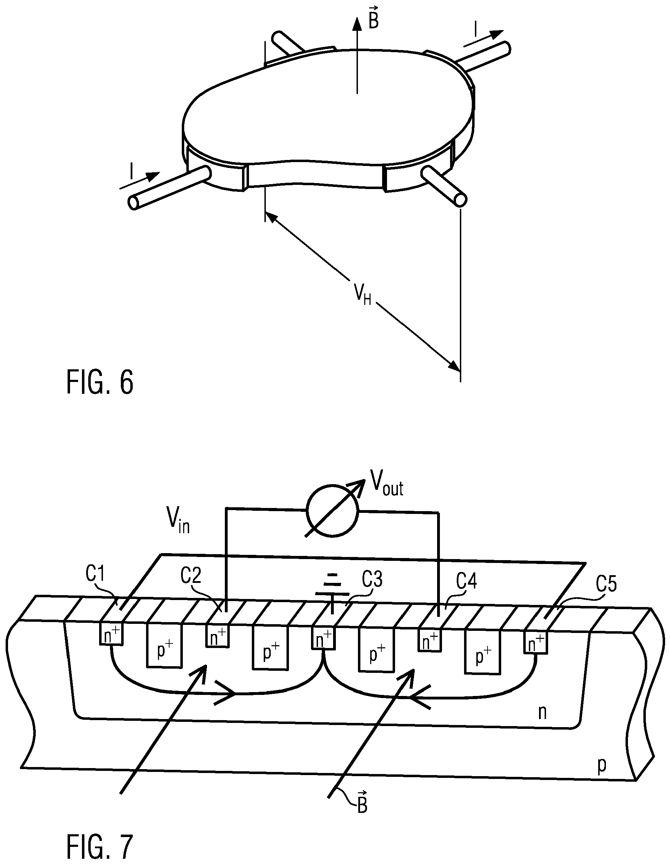

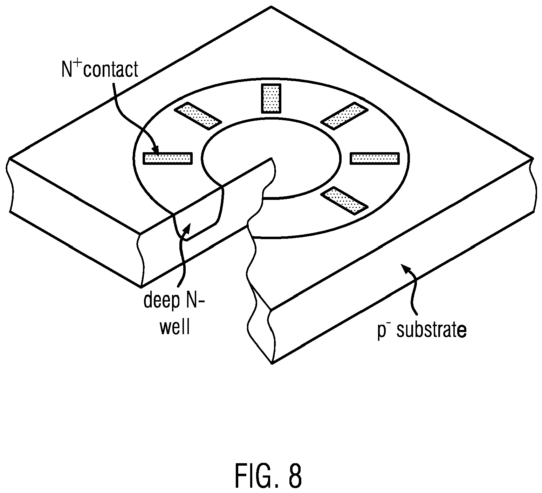

Weiterhin sind sogenannte vertikale Hallsensoren bekannt, die beispielsweise in dem Artikel T. Kaufmann, F. Purkl, P. Ruther, O. Paul: "NOVEL COUPLING CONCEPT FOR FIVE-CONTACT VERTICAL HALL DEVICES", Transducers'11, Beijing, China, June 5-9, 2011, Seiten 2855 bis 2858, (siehe Figur 7) oder in dem Artikel M. Banjevic, B. Furrer, R.S. Popović: "2D CMOS INTEGRATED MAGNETOMETER BASED ON THE MINIATURIZED CIRCULAR VERTICAL HALL DEVICE", Transducers 2009, Denver, CO, USA, June 21-25, 2009, pages 877 - 880, (siehe Figur 8) beschrieben sind. Derartige vertikale Hallsensoren werden durch längliche oder ringförmige leitende Bereiche mit je nach Ausführungsart drei bis 64 kollinearen bzw. ringförmig angeordneten Kontakten gebildet.

Figur 7 zeigt eine schematische Darstellung eines vertikalen Hall-Sensors mit fünf n⁺-Diffusionen zur Kontaktierung einer schmalen und tiefen n-Wanne für die Messung einer horizontalen Magnetfeldkomponente.

Wie aus Figur 7 hervorgeht, umfasst der Sensor eine tiefe n-Wanne mit fünf n⁺-dotierten Kontakten, die durch p⁺-Diffusionsgebiete von einander getrennt sind. Die äußersten Kontakte C1 und C5 sind kurzgeschlossen und bilden einen Eingangsanschluss. Legt man die Spannung Vᵢₙ an diesen Kontakt an und geht man davon aus, dass eine magnetische Flussdichte B quer zu der Sensorlängsachse gemessen werden soll, kann, wenn man einen in der Mitte liegenden n⁺-Kontakt C3 auf Masse legt, zwischen den Kontakten C2 und C4 eine Ausgangsspannung abgegriffen werden, die von dem Magnetfeld abhängt.

Um eine dreidimensionale Magnetfeldsensitivität zu erzielen, werden bei bekannten Sensorsystemen derartige Strukturen auf demselben Chip zu einem vektoriellen Magnetfeldsensor kombiniert (siehe z. B. P. Kejik et al.: "FIRST FULLY INTEGRATED 3D HALL PROBE", TRANSDUCERS '05, Seoul, Korea, June 5-9, 2005).

Alternativ ist auch bekannt, mehrere orthogonal zueinander angeordnete Chips mit gleichen Sensoren zu einem System zusammenzufügen, bei dem jeder Chip für die Messung einer Magnetfeldkomponente verantwortlich ist. Beispiele für diesen Ansatz sind die Systeme HE344 und HE444 der Fa. Hoeben Electronics, am 10. April 2013 im Internet herunterladbar unter http://www.hoeben.com/products.html.

Ein Nachteil der integrierten Lösung aus vertikalen und Hallplatten-basierten Sensoren ist die unterschiedliche Sensitivität des kombinierten Systems für die Magnetfeldkomponenten in der Ebene bzw. senkrecht zu dieser, wodurch sich die Komplexität des Systems aus Sensorchip und Schaltung wesentlich erhöht.

Im Fall einer Kombination von mehreren orthogonal zueinander angeordneten gleichartigen Chips erhöht sich dagegen der Aufbau- und Verbindungsaufwand und die Baugröße der Gesamtanordnung.

Weitere Lösungen zur Messung von drei Magnetfeldkomponenten besitzen den Nachteil der technisch aufwändigen Realisierung von seitlich an dreidimensionalen Substraten angebrachten oder vergrabenen Kontakten. Solche Sensoren sind z. B. aus der US 3373272 A und der DE 1197938 B bekannt. Darüber hinaus sind manche Sensoren mit unterschiedlichen Anordnungen von Kontakten an der Oberfläche eines Halbleiterchips durchaus in der Lage, mehrere und bis zu den drei Komponenten des Magnetfelds zu messen. Allerdings leiden sie ohne Ausnahme unter der ungleichen Sensitivität der Struktur für die Magnetfeldkomponenten (siehe z. B. US 2010/0097059 A1, DE 102009027338 A1 und DE 102010000769 A1).

Das Gesamtsystem erfordert daher einen erhöhten Kalibrier- und Datenauswertungsaufwand. Der fundamentale Grund liegt in der mangelnden Symmetrie der Strukturen für die drei Raumrichtungen x, y und z.

Die DE 10 2009 023338 A1 offenbart insbesondere mit Bezug auf die Figuren 4 und 6 einen Hallsensor mit insgesamt vier Elektrodenpaaren, die an zwei einander gegenüberliegenden Oberflächen eines aktiven Bereichs (Bezugszeichen 131) angeordnet sind. Dabei bezieht sich diese Druckschrift auf ein Hallsensorelement mit einem Substrat, das eine Hauptoberfläche aufweist, mit einem elektrisch leitfähigen aktiven Gebiet, das sich von der Hauptoberfläche in das Substrat erstreckt, und mit einer elektrisch leitfähigen ersten vergrabenen Schicht im Substrat, die das aktive Gebiet an einer ersten unteren Kontaktfläche kontaktiert. Bei der Durchführung der Messung wird ein elektrischer Messstrom zwischen einer ersten oberen Kontaktelektrode an der Hauptoberfläche und der ersten unteren Kontaktfläche durch das aktive Gebiet hindurch geleitet. Am aktiven Gebiet wird entlang einer Strecke, die geneigt zu einer Verbindungslinie zwischen der ersten unteren Kontaktfläche und der ersten oberen Kontaktelektrode verläuft, eine Hallspannung abgegriffen. Alternativ wird ein Messstrom über eine solche Strecke durch das aktive Gebiet geleitet und eine Hallspannung zwischen der ersten oberen Kontaktelektrode und der ersten unteren Kontaktfläche abgegriffen.

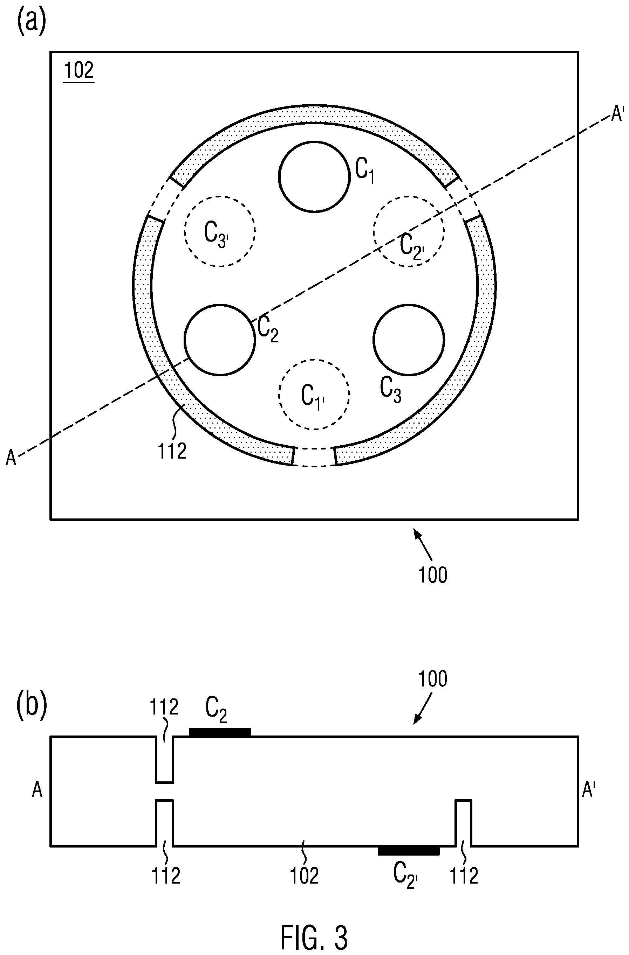

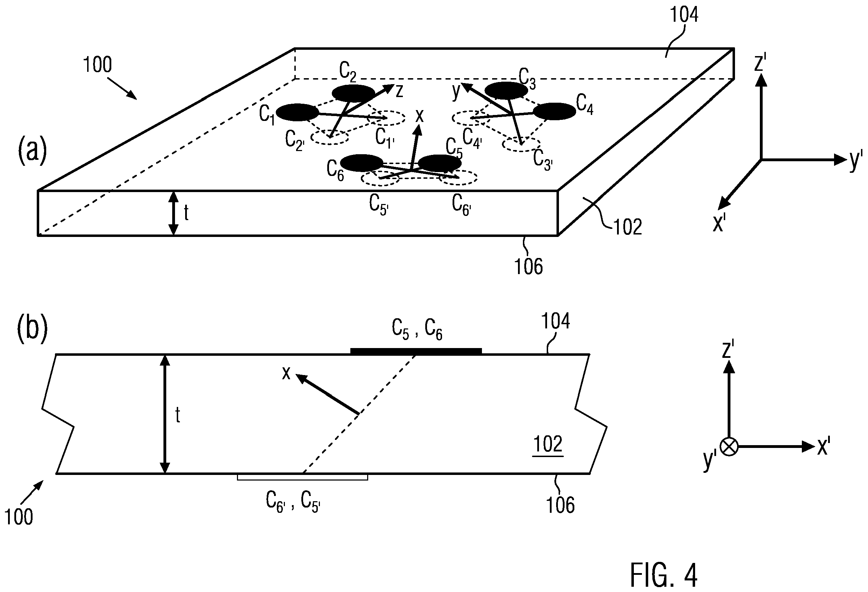

Die US 2010/097059 A1 offenbart diverse zweidimensionale und dreidimensionale Magnetfeldsensoren in mikromechanischer Bauweise. Die Anordnung der Figur 3 der Druckschrift verwendet jeweils vier Kontakte am linken und rechten Seitenrand eines leitfähigen Bereichs 52. Bei der Anordnung der Figur 4 liegen drei Kontakte (74c, 74d, 76a) in der rechten Seitenebene den vier Kontakten (74a, 74b, 76b, 76c) in der linken Seitenebene gegenüber.

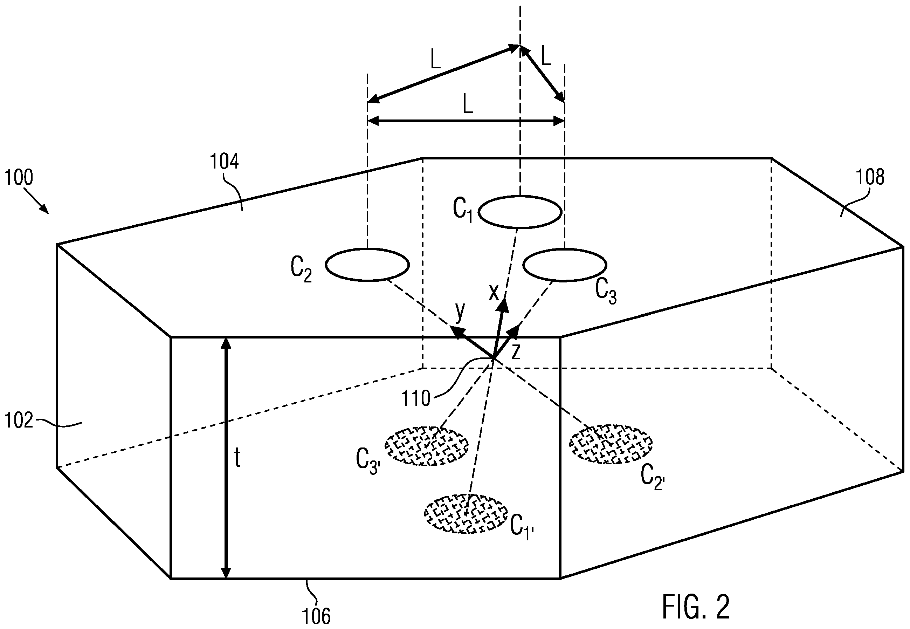

Die WO 2005/029604 A1 offenbart einen dreidimensionalen Halleffektsensor, bei dem auf allen sechs Seitenflächen eines Kubus ein Sensorchip angeordnet ist, der die in Figur 2 gezeigte Elektrodenanordnung trägt. Die Anschlüsse sind in der Mitte eines Substrats angeordnet und das Halbleitergebiet ist um den Umfang eines jeden Substrats herum angeordnet. Dabei handelt es sich bei den Strukturen S1 bis S8 um die halbleitenden Ecken des Kubus, die aus Halbleitermaterial der zusammengefügten Einzelstrukturen bestehen.

Die Aufgabe, die der vorliegenden Erfindung zugrunde liegt, besteht daher darin, einen dreidimensionalen Hallsensor anzugeben, der mit einer einzigen mit Anschlüssen versehenen Halbleiterstruktur alle drei Raumkomponenten des Magnetfeldes mit gleicher, d.h. isotroper Sensitivität, detektiert.

Diese Aufgabe wird durch den Gegenstand der unabhängigen Patentansprüche gelöst. Vorteilhafte Weiterbildungen des erfindungsgemäßen Hallsensors und Messverfahrens sind Gegenstand der abhängigen Patentansprüche.

Die vorliegende Erfindung basiert auf der Idee, den Sensor so aufzubauen, dass die Sensorstruktur eine inhärente Symmetrie aufweist. Auf diese Weise können die drei Magnetfeldkomponenten mit derselben Sensitivität gemessen werden und der Berechnungs- und Kalibrierungsaufwand reduziert sich signifikant.

Insbesondere umfasst ein Hallsensor gemäß der vorliegenden Erfindung einen elektrisch leitfähigen Grundkörper und mindestens drei Elektrodenpaare, wobei jedes der Elektrodenpaare einen ersten Anschluss und einen zweiten Anschluss hat, die an dem Grundkörper so angeordnet sind, dass ein Stromfluss von dem ersten zu dem zweiten Anschluss durch den Grundkörper hindurch erfolgen kann. Die Anschlüsse der Elektrodenpaare sind an mindestens zwei unterschiedlichen, einander gegenüber liegenden Flächen des Grundkörpers angeordnet.

Gemäß einer vorteilhaften Ausführungsform bilden mindestens drei Paare von Elektrodenpaaren mindestens drei Vierkontaktstrukturen, welche die Messung von jeweils einer räumlichen Komponente des Magnetfelds unter Nutzung des Halleffekts ermöglichen, wobei die Richtungen der mindestens drei gemessenen Komponenten des Magnetfelds den dreidimensionalen Raum aufspannen.

Bei entsprechender Dimensionierung wird zum einen dafür gesorgt, dass OffsetSpannungen, also Signale zwischen den Elektrodenpaaren quer zum Stromfluss in Abwesenheit eines Magnetfeldes, vermieden werden können und eine isotrope Sensitivität der Sensoranordnung sichergestellt ist.

Gemäß einer vorteilhaften Weiterbildung der erfindungsgemäßen Anordnung weisen verschiedene Paare von Elektrodenpaaren untereinander gemeinsame erste Anschlüsse auf der ersten Oberfläche und/oder gemeinsame zweite Anschlüsse auf der zweiten Oberfläche auf. Dadurch wird die Struktur und ihre Verbindung mit externen Systemkomponenten, wie zum Beispiel Schaltungen oder Messinstrumenten, vereinfacht.

Eine mit Fabrikationsmethoden der Halbleitertechnologie leichter vereinbare Sensoranordnung trägt mindestens drei erste Anschlüsse in einer Ebene auf einer ersten Oberfläche des Grundkörpers und mindestens drei zweite Anschlüsse in einer Ebene auf einer zweiten Oberfläche des Grundkörpers, und die erste und zweite Oberfläche liegen einander gegenüber. Eine solche Anordnung ist in vorteilhafter Weise mit den Standardverfahren der Halbleitertechnologie kompatibel. Beispielsweise sind die erste und zweite Oberfläche im Wesentlichen parallel zueinander angeordnet.

Für eine Vereinfachung der Berechnung des dreidimensionalen Magnetfeldvektors aus den gemessenen räumlichen Komponenten können die Paare von Elektrodenpaaren rotationssymmetrisch um eine Achse angeordnet sein, welche die erste und zweite Oberfläche durchdringt. Ebenso kann die Form des Grundkörpers symmetrisch sein und mindestens dieselbe Rotationssymmetrie besitzen wie die Anordnung der Elektrodenpaare.

Mit den wenigsten Anschlüssen kann der erfindungsgemäße Magnetfeldsensor realisiert werden, wenn die mindestens drei ersten Anschlüsse und die mindestens drei zweiten Anschlüsse so angeordnet sind, dass ihre Verbindungslinien miteinander jeweils ein Dreieck bilden. In anderen Worten: Gemäß einer speziellen Weiterentwicklung des erfindungsgemäßen Konzeptes fallen Einzelanschlüsse der Paare von Elektrodenpaaren zusammen, so dass sich die Gesamtzahl der Anschlüsse reduziert.

Das durch die Verbindungslinien zwischen den ersten und zweiten Anschlüssen der jeweiligen Elektrodenpaare gebildete Koordinatensystem muss dabei weder rechtwinklig, noch übereinstimmend mit dem für die Ausgabe des **B**-Feld-Signals verwendeten zweiten Koordinatensystem sein. Eine entsprechende Umrechnung zwischen den durch die Elektrodenanordnung definierten ersten Koordinatensystem und dem zweiten Koordinatensystem, in welchem die Messsignale für das **B**-Feld ausgegeben werden sollen, ist nach bekannten mathematischen Methoden der Koordinatentransformation stets möglich.

Beispielsweise können drei erste Anschlüsse auf einer ersten Fläche des Grundkörpers ein gleichseitiges Dreieck bilden, gerechnet von den Flächenschwerpunkten, beispielsweise den Mittelpunkten, der Anschlüsse, und die drei zweiten Anschlüsse können auf der gegenüberliegenden Grundkörperfläche ebenfalls ein gleichseitiges Dreieck bilden. Diese beiden Dreiecke können im Idealfall übereinander zentriert und um 180° zueinander gedreht auf den Oberflächen angeordnet sein. Dadurch kreuzen sich die Verbindungslinien zwischen den jeweiligen ersten und zweiten Anschlüssen in einem gemeinsamen Punkt.

Dieser liegt in der Mitte des Grundkörpers, wenn die beiden Dreiecke gleich groß sind. Ansonsten liegt er näher an der Oberfläche mit dem kleineren Dreieck. Der gemeinsame Punkt kann als Ursprung eines Koordinatensystems definiert werden, das orthogonal ist und symmetrisch um einen Normalenvektor zur Oberfläche des Grundkörpers angeordnet ist, d. h. die Achsen des Koordinatensystems schließen mit dem Normalenvektor zur Oberfläche des Grundkörpers den gleichen Winkel ein. Die ersten und zweiten Anschlüsse bilden damit jeweils ein Elektrodenpaar aus, wobei immer zwei dieser Elektrodenpaare zur Messung einer Magnetfeldkomponente betrieben werden können. Bei geeigneter Dimensionierung des Bauteils lassen sich auf diese Weise Hallspannungen messen, die in erster Näherung proportional zu den Magnetfeldkomponenten Bₓ, B_{y} und B_{z} sind und keinen geometrischen Offsetanteil haben. Aufgrund der Symmetrie dieser Struktur werden alle drei Magnetfeldkomponenten mit derselben Sensitivität gemessen.

Durch eine Koordinatentransformation mittels bekannter mathematischer Verfahren können die Magnetfeldkomponenten in dem durch die Anschlüsse gebildeten Koordinatensystem leicht in Komponenten umgerechnet werden, die beispielsweise durch Kanten des Bauelements definiert sind.

Die erforderliche Sensitivität wird am besten dadurch erreicht, dass der Grundkörper aus einem niedrigdotierten Halbleitermaterial mit hoher Ladungsträgermobilität gefertigt ist. Dies kann beispielsweise Silizium, aber auch Indiumarsenid oder Indiumantimonid sein. Generell können alle einem Fachmann bekannten Materialien mit hoher Hallsensitivität gemäß den Prinzipien der vorliegenden Erfindung eingesetzt werden. Auch gemischte Materialien oder Heterostrukturen können entsprechend verwendet werden, wie dies einem Fachmann bekannt ist.

Eine kostengünstige und etablierte Materialwahl stellt die Fertigung des Grundkörpers aus n-leitendem Silizium dar.

Weiterhin können an dem Magnetfeldsensor gemäß der vorliegenden Erfindung Stromführungsstrukturen vorgesehen sein. In dieser Ausgestaltung des Magnetfeldsensors wird der Grundkörper durch zusätzliche, in den Grundkörper eingebrachte und um die Anschlüsse angeordnete Stromführungsstrukturen beeinflusst. Dadurch wird erreicht, dass der Stromfluss auf einen zentralen Bereich des Grundkörpers konzentriert wird, wodurch die Stromflussdichte und die Sensitivität erhöht und die Größe der Offsets vermindert werden kann.

Ein Verfahren zum Messen eines räumlichen Magnetfeldes mittels eines dreidimensionalen Hallsensors gemäß der vorliegenden Erfindung basiert auf der Grundidee, dass alle Elektrodenpaare grundsätzlich gleichberechtigt sind und im Verlauf der jeweiligen Messungen stets sowohl als Speisestromanschlüsse, wie auch als Messanschlüsse für die Hallspannung eingesetzt werden können. Diese vollkommene Symmetrie und Gleichberechtigung erlaubt außerdem, dass die bekannten Orthogonal-Switching-Verfahren und Spinning-Current-Verfahren zum Unterdrücken von Offsetkomponenten verwendet werden. Hierbei werden die Anschlüsse eines Paares von Elektrodenpaaren während eines Messschritts einfach oder mehrfach zyklisch vertauscht und somit können unerwünschte geometrische, piezoresistive oder thermoelektrische Offsetkomponenten durch eine Mittelung eliminiert werden. Das Orthogonal-Switching-Verfahren und das Spinning-Current-Verfahren sind beispielsweise in dem Artikel P. Munter: "A LOW-OFFSET SPINNING-CURRENT HALL PLATE", Sensors and Actuators A 22, No.1-3 (1989) 743-746, beschrieben.

Das Verfahren gemäß der vorliegenden Erfindung umfasst die Schritte
(a) Einprägen eines ersten Speisestroms, der vom ersten zum zweiten Anschluss eines ersten Elektrodenpaars fließt;
(b) Abgreifen einer ersten Hallspannung zwischen dem ersten und zweiten Anschluss eines zweiten der Elektrodenpaare;
(c) Berechnen einer ersten Magnetfeldkomponente, die quer zu dem eingeprägten Speisestrom und quer zu einer Verbindungslinie zwischen dem ersten und zweiten Anschluss des zweiten der Elektrodenpaare verläuft, aus der gemessenen ersten Hallspannung.

Erfindungsgemäß werden diese drei Schritte mit vertauschten Elektrodenpaaren durchgeführt, so dass schließlich mindestens drei Magnetfeldkomponenten ermittelt werden, aus denen der dreidimensionale Magnetfeldvektor **B** berechnet werden kann. Die Messung kann bei geeigneter Dimensionierung der Sensoranordnung vollkommen offsetfrei erfolgen, wenn die an der Messung beteiligten Anschlüsse innerhalb einer jeden Hallspannungsmesskonfigurationen einmal oder mehrfach zyklisch vertauscht werden.

Wenn das Verfahren speziell einen Hallsensor verwendet, bei dem die mindestens drei ersten Anschlüsse und die mindestens drei zweiten Anschlüsse so angeordnet sind, dass ihre Verbindungslinien miteinander jeweils ein Dreieck bilden, führt dies dazu, dass die drei bestimmten Magnetfeldkomponenten bei geeigneter Dimensionierung der Elektrodenanordnung idealerweise senkrecht aufeinander stehen und isotrop gemessen werden. Damit wird die Berechnung des räumlichen Magnetfeldes in einem gewünschten Koordinatensystem besonders einfach.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einzelne Merkmale oder Merkmalskombinationen aus den gezeigten und beschriebenen Ausführungsformen für sich genommen eigenständige, erfinderische oder erfindungsgemäße Lösungen darstellen.

Es zeigen:
- **Fig. 1**: eine perspektivische Prinzipdarstellung eines dreidimensionalen Hallsensors gemäß einer ersten Ausführungsform;
- **Fig. 2**: eine perspektivische Prinzipdarstellung eines dreidimensionalen Hallsensors gemäß einer zweiten Ausführungsform;
- **Fig. 3**: eine schematische Darstellung einer Ausgestaltung des Magnetfeldsensors mit Stromführungsstrukturen (a) in einer Draufsicht und (b) als Schnitt entlang der Linie A-A' der Figur 3(a);
- **Fig. 4**: eine Prinzipdarstellung eines dreidimensionalen Hallsensors gemäß einer weiteren Ausführungsform, (a) in perspektivischer Darstellung, (b) als Seitenansicht;
- **Fig. 5**: (a)-(j) schematische Darstellungen weiterer vorteilhafter Elektrodengeometrien;
- **Fig. 6**: eine perspektivische Prinzipdarstellung eines bekannten dreidimensionalen Hallsensors;
- **Fig. 7**: einen weiteren bekannten vertikalen Hallsensor;
- **Fig. 8**: einen weiteren bekannten Hallsensor.

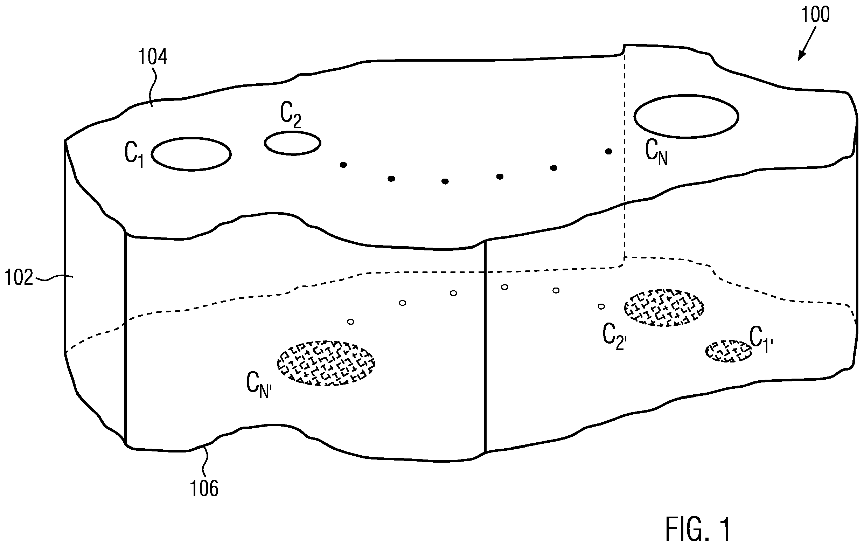

Die Erfindung soll nachfolgend mit Bezug auf die Figuren näher erläutert werden. Eine erste Ausführungsform eines dreidimensionalen Hallsensors 100 ist schematisch in Figur 1 dargestellt.

Figur 1 zeigt den prinzipiellen Aufbau dieses neuen Magnetfeldsensors in seiner allgemeinsten Ausgestaltung. Der Magnetfeldsensor 100 umfasst ein leitfähiges Substrat 102, das in einer Raumrichtung durch zwei idealer- aber nicht notwendigerweise ebene Flächen 104, 106, die idealer- aber nicht notwendigerweise parallel zueinander ausgerichtet sind, begrenzt wird. Die Begrenzungsflächen 104, 106 werden im Folgenden als die obere bzw. die untere Begrenzungsfläche bezeichnet. Die leitfähige Struktur kann in den beiden anderen Raumrichtungen begrenzt sein. In der oberen bzw. der unteren Begrenzungsfläche 104, 106 sind jeweils mindestens drei Anschlüsse Cᵢ (i = 1,2,...,N mit N ≥ 3) und C_{i'} (i' = 1,2,...,N' mit N' ≥ 3 und nicht zwangsläufig gleich N) integriert, über welche die Struktur 100 elektrisch angesteuert werden kann und magnetfeldabhängige Messsignale ausgelesen werden können.

Im Betrieb des Magnetfeldsensors 100 wird zwischen einem Anschluss Cᵢ einer der Begrenzungsflächen 104 und einem zweiten Anschluss C_{i'} der gegenüberlegenden Begrenzungsfläche 106 eine Speisespannung V_{bias} angelegt oder äquivalent ein Speisestrom I_{bias} eingespeist bzw. entnommen, und an einem weiteren Elektrodenpaar Cⱼ-C_{j'} mit j ≠ i und j' ≠ i' die in erster Näherung linear von einer Magnetfeldkomponente B₁ abhängende Spannungsdifferenz ΔV_{Hall,1}(B₁) = Vⱼ(B₁) - V_{j'}(B₁) gemessen.

Zur Messung zweier weiterer, von B₁ und voneinander linear unabhängiger Komponenten B₂ und B₃ des Magnetfelds werden weitere Elektrodenpaare Cₖ-C_{k'} bzw. Cₗ-C_{l'} (mit l ≠ k und l' ≠ k') sowie Cₘ-C_{m'} bzw. Cₙ-C_{n'} (mit n ≠ m und n' ≠ m') zum Anlegen der Speisespannung V_{bias} (äquivalent zum Einspeisen des Speisestroms I_{bias}) bzw. zur Messung magnetfeldabhängiger Spannungsdifferenz ΔV_{Hall,2}(B₂) oder ΔV_{Hall,3}(B₃) kontaktiert. Die Magnetfeldkomponenten Bᵢ (i = 1...3) stehen idealer- aber nicht notwendigerweise senkrecht aufeinander.

Im nichtidealen Fall lassen sich aus den drei Messspannungen in einem weiteren Schritt und nach vorheriger Kalibrierung des Sensors drei orthogonale Magnetfeldkomponenten extrahieren. Aus diesen lassen sich durch eine weitere Koordinatentransformation die drei Komponenten von **B** in einem beliebigen Koordinatensystem berechnen.

Der Nachteil des beliebig geformten Substrats in Figur 1 mit seinen Anschlüssen liegt in den im Allgemeinen hohen Offsetspannungen und den unterschiedlichen Sensitivitäten für die Messung der drei Komponenten von **B.**

Wie in der Figur 2 gezeigt, schlägt die vorliegende Erfindung Magnetfeldsensoren vor, mit denen drei linear unabhängige Komponenten B₁, B₂ und B₃ des Magnetfeldvektors **B** aufgrund der inhärenten Symmetrie der Sensorstruktur mit dem Halleffekt mit derselben Sensitivität gemessen werden können. Die hierfür notwendigen Anschlüsse befinden sich auf gegenüberliegenden Flächen der Sensorstruktur. Bei zweckmäßiger Dimensionierung der Sensorstruktur sind die drei gemessenen Magnetfeldkomponenten orthogonal zueinander und diese werden mit geringem, bei zweckmäßiger Dimensionierung der Sensorstruktur verschwindendem Offset gemessen.

Eine bevorzugte Ausgestaltung des Magnetfeldsensors 100 weist daher, wie in Figur 2 dargestellt, ein leitfähiges Substrat 102 mit zwei zueinander parallelen, planaren Begrenzungsflächen 104, 106 sowie seitliche Randflächen 108 und sechs Anschlüssen auf und besitzt eine dreifache Rotationssymmetrie und Inversionssymmetrie. Die Anschlüsse auf Vorder- und Rückseite sind symmetrisch bezüglich Drehungen um ±120° um die senkrechte Symmetrieachse angeordnet. Die Anschlussanordnungen der Vorder- und Rückseite sind um 180° gegenüber einander gedreht.

Der Magnetfeldsensor 100 gemäß dieser Ausgestaltung weist eine Inversionssymmetrie bezüglich eines Symmetriezentrums und eine dreizählige Rotationssymmetrie bezüglich einer auf den Begrenzungsflächen senkrecht stehenden und das Symmetriezentrum enthaltenden Achse auf. Seine drei Anschlüsse C₁, C₂, C₃ auf der oberen Begrenzungsfläche 104 und seine drei Anschlüsse C_{1'}, C_{2'}, C_{3'} auf der unteren Begrenzungsfläche 106 bilden somit je gleichseitige Dreiecke mit der Kantenlänge L gemessen von Anschlusszentrum zu Anschlusszentrum. Die Verbindungslinien zwischen C₁ und C_{1'}, zwischen C₂ und C_{2'} sowie zwischen C₃ und C_{3'} kreuzen sich im Symmetriezentrum 110 in der Mitte des Chips.

Dieser gemeinsame Punkt 110 kann als Ursprung eines kartesischen Koordinatensystems definiert werden, von dem aus eine x-Achse ungefähr in Richtung des Anschlusses C₁, eine y-Achse ungefähr in Richtung des Anschlusses C₂ sowie eine z-Achse ungefähr in die Richtung des Anschlusses C₃ zeigt. Die x-, y- und z-Achsen sind dabei zueinander orthogonal und symmetrisch um die senkrechte Symmetrieachse des Magnetfeldsensors angeordnet. Die Situation ist in Figur 2 skizziert. Es ist anzumerken, dass die direkten Verbindungslinien zwischen den Elektrodenpaaren sich bei allgemeinen Werten des Kontaktabstands L und Substratdicke t nicht unbedingt orthogonal kreuzen.

Im bevorzugten Betrieb des Magnetfeldsensors 100 aus Figur 2 wird zunächst zwischen den Anschlüssen C₁-C_{1'} eine Speisespannung V_{bias} angelegt oder äquivalent ein Speisestrom I_{bias} eingespeist bzw. entnommen, und zwischen den Anschlüssen C₂-C_{2'} die in erster Näherung von der Magnetfeldkomponente B₁ linear abhängende Spannungsdifferenz ΔV_{Hall,1}(B₁) = ΔV_{offset,1} + S_{Hall}B₁ gemessen, wobei ΔV_{offset,1} einen magnetfeldunabhängigen Offset und S_{Hall} eine magnetische Sensitivität bezeichnen.

Durch Anwendung der Orthogonal-Switching-Methode oder der Spinning-Current-Methode, d.h. einfacher oder mehrfacher zyklischer Vertauschung der Speiseanschlüsse bei Anwendung desselben Speisestromwerts I_{bias} kann der Offset ΔV_{offset,1} durch Mittelung der gemessenen Spannungsdifferenzen erfolgreich eliminiert werden, sodass das offsetbereinigte Messsignal S_{Hall}B₁ übrigbleibt. Die Richtung von B₁ zeigt dabei aus der von den Anschlüssen C₁, C_{1'}, C₂ und C_{2'} aufgespannten schiefen Ebene heraus und weist tendenziell in Richtung der z-Achse.

In einer zweiten Messung wird der Magnetfeldsensor 100 mit den Anschlüssen C₂-C_{2'} (Speisespannung V_{bias} oder äquivalent Speisestrom I_{bias}) und den Anschlüssen C₃-C_{3'} (Bestimmung einer zweiten Magnetfeldkomponente B₂ aus dem zweiten offsetbereinigten Messsignal S_{Hall}B₂) betrieben.

In einer dritten Messung schließlich wird der Magnetfeldsensor 100 mit den Anschlüssen C₃-C_{3'} (Speisespannung V_{bias} oder äquivalent Speisestrom I_{bias}) und den Anschlüssen C₁-C_{1'} (Bestimmung einer dritten Magnetfeldkomponente B₃ aus dem dritten offsetbereinigten Messsignal S_{Hall}B₃) betrieben.

Aufgrund der dreizähligen Symmetrie des Magnetfeldsensors werden die drei Komponenten B₁, B₂ und B₃ des Magnetfeldvektors **B** mit derselben Sensitivität S_{Hall} gemessen. Die Komponenten B₂ und B₃ zeigen dabei tendenziell in die x- bzw. y-Richtung. Bei entsprechender Dimensionierung der Magnetfeldsensor- und Anschlussgeometrien lässt sich erreichen, dass die drei gemessenen Magnetfeldkomponenten aufeinander senkrecht stehen, d.h., dass sie die drei Komponenten des Magnetfeldvektors **B** in einem kartesischen Koordinatensystem darstellen. Ebenso lässt sich gleichzeitig erreichen, dass der Offset im Idealfall verschwindet, bzw. nur geringe Offsets wegkompensiert werden müssen.

In einer weiteren Ausgestaltung des Magnetfeldsensors weisen die Anschlüsse die oben genannte dreizählige Symmetrie und Inversionssymmetrie nur näherungsweise auf. Es zeigt sich, dass auch unter solchermaßen nichtidealen Bedingungen die Messung von drei unabhängigen Magnetfeldkomponenten und die Berechnung des Magnetfeldvektors **B** aus diesen Komponenten gut möglich sind.

In einer weiteren Ausgestaltung des Magnetfeldsensors sind die beiden oberen und unteren Begrenzungsflächen nur näherungsweise parallel und eben. Es zeigt sich, dass auch unter solchermaßen nichtidealen Bedingungen die Messung von drei unabhängigen Magnetfeldkomponenten und die Berechnung des Magnetfeldvektors **B** aus diesen Komponenten gut möglich sind. In einer weiteren Ausgestaltung des Magnetfeldsensors erfüllen die seitlichen Randflächen die Symmetriebedingungen nicht. Es zeigt sich, dass bei einem genügend großen Substrat (groß im Vergleich zu L und t) die genaue Form des Substrats in der Substratebene nur einen geringen oder sogar vernachlässigbaren Einfluss auf die Eigenschaften des Magnetfeldsensors wie Sensitivität und Offset ausübt.

Figur 3 zeigt eine schematische Darstellung einer weiteren vorteilhaften Ausführungsform des Magnetfeldsensors mit Stromführungsstrukturen 112.

In dieser Ausgestaltung des Magnetfeldsensors wird das Substrat 102 durch zusätzliche, in das Substrat 102 eingebrachte und um die Anschlüsse angeordnete Stromführungsstrukturen 112 beeinflusst. Dadurch wird erreicht, dass der Stromfluss auf einen zentralen Bereich des Substrats konzentriert wird, wodurch die Stromflussdichte und die Sensitivität erhöht und die Größe der Offsets vermindert werden kann.

Solche Stromführungsstrukturen 112 können auf verschiedene Art und Weise realisiert werden. Beispielsweise können sie als ins Substrat eingebrachte Strukturierungen (Schlitze, Trenches, Kavitäten) hergestellt werden. Diese können, auch nur teilweise, durch nichtleitendes Material aufgefüllt sein. Die Stromführungsstrukturen 112 können aber auch durch in das Substrat 102 eindiffundierte Bereiche mit einer der Substratdotierung entgegengesetzten Dotierung gebildet sein, wenn es sich beim Substrat um ein Halbleitermaterial handelt.

Dabei ist es zweckmäßig, aber nicht unbedingt notwendig, dass der von den Stromführungsstrukturen 112 definierte Bereich des Substrats 102 die oben genannten Symmetrien aufweist, welche im Idealfall eine Messung dreier orthogonaler Komponenten des Magnetfelds mit identischer Sensitivität und verschwindendem Offset ermöglicht. Das Substrat 102 selbst muss dabei die Symmetriebedingungen nicht unbedingt erfüllen, sondern es kann eine einfachere Form, z.B. die Quaderform, aufweisen.

Die Fertigung des Magnetfeldsensors gemäß der vorliegenden Erfindung benutzt beispielsweise Substrate und Methoden der Mikroelektronik (z.B. thermische Oxidation, Ionenimplantation, Diffusion, Sputtern von Metallschichten, Wafersägen, ...) sowie der Mikrosystemtechnik (reaktives, anisotropes Tiefenätzen von Silizium (deep reactive ion etching, Bosch-Prozess)).

Im Fall einer Geometrie des Sensors mit planparallelen Begrenzungsflächen 104, 106 werden diese Prozessschritte analog zur Fertigung von halbleiter-basierten integrierten Schaltungen durchgeführt. Hierbei werden in der Vorder- bzw. Rückseite z. B. von n-dotierten Siliziumwafern zunächst durch Ionenimplantation n⁺-Kontaktdiffusionen eingebracht und thermisch aktiviert.

Die Ionenimplantation wird z.B. durch ein strukturiertes thermisches Siliziumoxid auf der Vorder- und Rückseite des Siliziumwafers begrenzt. Die elektrische Kontaktierung der n⁺-Diffusionen erfolgt z.B. durch Abscheiden und Strukturieren einer Metallisierung, z.B. Aluminium, deren Kontaktwiderstand zu den n⁺-dotierten Bereichen der leitfähigen Struktur durch einen thermischen Ausheilschritt reduziert wird. Dies ist insbesondere bei niedrigdotiertem Halbleitermaterial, das einen starken Halleffekt zeigt, von Vorteil.

Die metallisierten Kontakte können als Kontaktpads genutzt werden oder alternativ über leitende Linien mit Kontaktpads verbunden sein. Analog können die n⁺-Diffusionen über weitere diffundierte Bereiche mit Kontaktpads verbunden werden. Die symmetrische Struktur wird durch einseitige oder auch beidseitige Strukturierung des Siliziumsubstrats erzielt, z.B. durch reaktives Tiefenätzen von Silizium.

Alternativ kann das Substrat auch durch tiefengeätzte Kavitäten strukturiert werden, welche den Stromfluss zwischen den Anschlüssen auf einen symmetrischen zentralen Bereich konzentrieren. Das Substrat des Magnetfeldsensors selbst kann in diesem Fall auch einfach durch Wafersägen aus dem Siliziumwafer herausgetrennt werden. Diese Geometrie erleichtert die Handhabung des Magnetfeldsensors bei Verwendung von Standardequipment der Aufbau- und Verbindungstechnik.

Die elektrische Verbindung des Magnetfeldsensors kann durch Flip-Chip-Technologie, Drahtbonden oder andere gängige Verfahren der Aufbau- und Verbindungstechnik erfolgen.

Die gemäß der vorliegenden Erfindung vorgeschlagenen drei Elektrodenpaare definieren die Mindestzahl der benötigten Kontakte zur Messung von drei linear unabhängigen Magnetfeldkomponenten. Sieht man mehr als drei Elektrodenpaare vor, indem man beispielsweise vier, fünf, sechs oder mehr im Quadrat, Pentagon oder Hexagon angeordnete Anschlüsse auf jeder Chipfläche vorsieht, lassen sich durch Wahl verschiedener Vierergruppen von Anschlüssen auf den beiden Chipflächen Hallmessungen durchführen, welche jeweils Linearkombinationen der drei Magnetfeldkomponenten darstellen. Aus mindestens drei solchen Messungen lassen sich schließlich die drei linear unabhängigen Komponenten des Magnetfelds extrahieren. Werden mehr als drei derartige Messungen ausgewertet, so sind deren Resultate selbstverständlich untereinander nicht mehr linear unabhängig. Diese Redundanz lässt sich aber für eine erhöhte Genauigkeit der extrahierten Magnetfeldkomponenten nutzen.

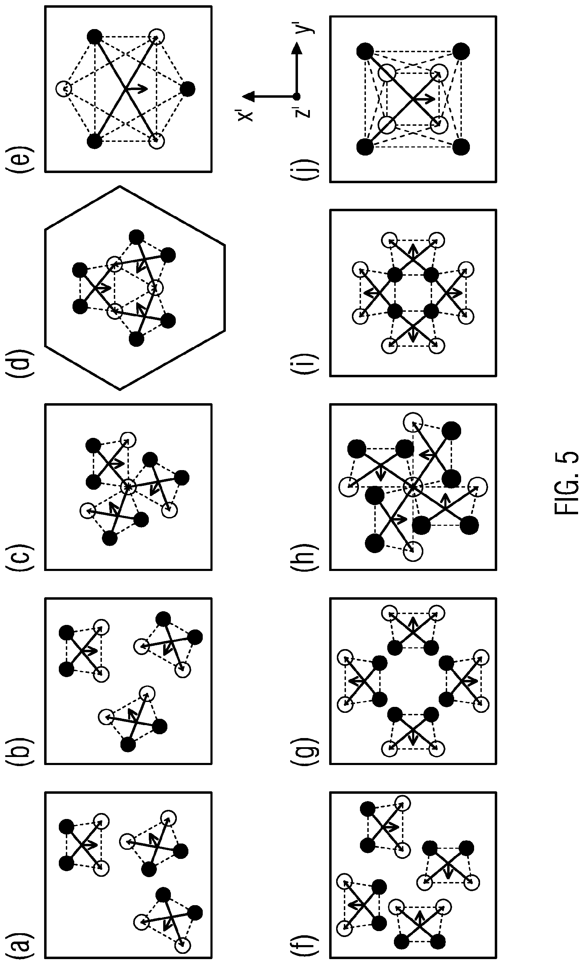

Mit Bezug auf die Figuren 4 und 5 werden nachfolgend weitere vorteilhafte Ausführungsformen des Magnetfeldsensors gemäß der vorliegenden Erfindung erläutert, die zum Teil mehr als drei Elektrodenpaare besitzen.

Figur 4 zeigt eine Anordnung von Elektrodenpaaren, bei der jeweils zwei Elektrodenpaare zu Paaren von Elektrodenpaaren, d. h. zu Vierkontaktstrukturen, welche unterschiedliche Magnetfeldkomponenten zu messen erlauben, zusammengeschlossen sind. Figur 4(a) ist dabei eine perspektivische Ansicht dreier Paare von Elektrodenpaaren, die zur Messung von drei Komponenten des Magnetfelds in den Richtungen x, y und z verwendet werden können. Die Richtungen x, y und z spannen dabei den dreidimensionalen Raum auf.

Figur 4(b) zeigt eine Seitenansicht in y'-Richtung des Paars von Elektrodenpaaren (C₅,C_{5'};C₆,C_{6'}). Die x-Richtung bezeichnet die Richtung der Komponente des Magnetfelds, welche sich mit dem Paar von Elektrodenpaaren (C₅,C_{5'};C₆,C_{6'}) mittels des Halleffekts bestimmen lässt.

Figur 5 zeigt weitere vorteilhafte Varianten der Elektrodenanordnung, die aber nicht alle unter die beanspruchte Erfindung fallen, insbesondere die Beispiele, die keine dreifache RotationsSymmetrie haben. In den Figuren 5(a) und (f) sind Magnetfeldsensoren mit beliebiger Anordnung von Paaren von Elektrodenpaaren gezeigt, bei denen mindestens drei Paare von Elektrodenpaaren jeweils eine Vierkontaktstruktur bilden, welche die Messung einer räumlichen Komponente des Magnetfelds unter Nutzung des Halleffets ermöglicht, wobei die Richtungen der mindestens drei gemessenen Komponenten des Magnetfelds den dreidimensionalen Raum aufspannen.

Die Figuren 5(c) bis (e) sowie Figuren 5(h) bis (j) zeigen Magnetfeldsensoren mit gemeinsamen Anschlüssen der Paare von Elektrodenpaaren, wobei verschiedene Paare von Elektrodenpaaren untereinander gemeinsame erste Anschlüsse auf der ersten Oberfläche und/oder gemeinsame zweite Anschlüsse auf der zweiten Oberfläche aufweisen.

Weiterhin zeigen die Figuren 5(b) bis 5(e) sowie 5(g) bis 5(j) Beispiele für eine rotationssymmetrische Anordnung, bei der die Paare von Elektrodenpaaren rotationssymmetrisch um eine Achse angeordnet sind, welche die erste und zweite Oberfläche durchdringt.

Die Figuren 5(d) sowie 5(g) bis 5(j) sind außerdem Beispiele für Magnetfeldsensoren mit symmetrischem Grundkörper, wobei die Form des Grundkörpers mindestens dieselbe Rotationssymmetrie besitzt wie die Anordnung der Elektrodenpaare.

Figur 5(e) stellt einen Magnetfeldsensor mit einer minimalen Anzahl von drei ersten Anschlüssen und drei zweiten Anschlüssen dar, wobei die drei ersten Anschlüsse und die drei zweiten Anschlüsse so angeordnet sind, dass ihre Verbindungslinien miteinander jeweils ein Dreieck bilden.

In den Figuren 5(e) und 5(j) ist jeweils ein Paar von Elektrodenpaaren besonders hervorgehoben, während die anderen Paare durch separate, jeweils vier Anschlüsse zu einer Vierkontaktstruktur verbindende unterschiedliche Strich-Linien oder Strich-Punkt-Linien angedeutet sind.

## Patentansprüche

1. Dreidimensionaler Hallsensor zum Detektieren eines räumlichen Magnetfeldes, wobei der Hallsensor (100) einen elektrisch leitfähigen Grundkörper (102) und mindestens drei Elektrodenpaare (C₁, C_{1'}; ...C_{N}, C_{N'}) umfasst,
wobei jedes der Elektrodenpaare einen ersten Anschluss (C₁, ... C_{N}) und einen zweiten Anschluss (C_{1'} ... C_{N'}) umfasst, die an dem Grundkörper (102) so angeordnet sind, dass ein Stromfluss von dem ersten zu dem zweiten Anschluss durch den Grundkörper (102) hindurch erfolgen kann,
wobei mindestens drei erste Anschlüsse auf einer ersten Oberfläche (104) des Grundkörpers angeordnet sind und mindestens drei zweite Anschlüsse auf einer zweiten, von der ersten unterschiedlichen, Oberfläche (106) des Grundkörpers angeordnet sind, und wobei die erste und die zweite Oberfläche einander gegenüberliegen,
wobei mindestens drei Paare von Elektrodenpaaren mindestens drei Vierkontaktstrukturen bilden, welche die Messung jeweils einer räumlichen Komponente des Magnetfelds unter Nutzung des Halleffekts ermöglichen, wobei die Richtungen der mindestens drei gemessenen Komponenten des Magnetfelds den dreidimensionalen Raum aufspannen, **dadurch gekennzeichnet, dass**
die ersten Anschlüsse (C₁, ... C_{N}) und die zweiten Anschlüsse (C_{1'} ... C_{N'}) so angeordnet sind, dass die Anschlüsse eines jeden Elektrodenpaares (C₁, C_{1'}; ...C_{N}, C_{N'}) eine dreizählige Rotationssymmetrie bezüglich einer auf den Begrenzungsflächen senkrecht stehenden Achse aufweisen.

2. Hallsensor nach Anspruch 1, wobei verschiedene Paare von Elektrodenpaaren untereinander gemeinsame erste Anschlüsse auf der ersten Oberfläche und/oder gemeinsame zweite Anschlüsse auf der zweiten Oberfläche aufweisen.

3. Hallsensor nach Anspruch 1 oder 2, wobei die erste und zweite Oberfläche im Wesentlichen parallel zueinander angeordnet sind.

4. Hallsensor nach einem der vorhergehenden Ansprüche, wobei die Paare von Elektrodenpaaren rotationssymmetrisch um eine Achse angeordnet sind, welche die erste und zweite Oberfläche (104, 106) durchdringt.

5. Hallsensor nach Anspruch 4, wobei die Form des Grundkörpers symmetrisch ist und mindestens dieselbe Rotationssymmetrie besitzt wie die Anordnung der Elektrodenpaare.

6. Hallsensor nach einem der vorhergehenden Ansprüche, wobei die mindestens drei ersten Anschlüsse und die mindestens drei zweiten Anschlüsse so angeordnet sind, dass ihre Verbindungslinien miteinander jeweils ein Dreieck bilden.

7. Hallsensor nach einem der vorhergehenden Ansprüche, wobei mindestens die ersten Anschlüsse wenigstens teilweise von einer Stromführungsstruktur (112) mit geringerer elektrischer Leitfähigkeit als das Grundkörpermaterial umgeben sind.

8. Hallsensor nach Anspruch 7, wobei die Stromführungsstruktur (112) als in den Grundkörper eingebrachte Strukturierungen, vorzugsweise Schlitze, Gräben, oder Kavitäten, hergestellt ist.

9. Hallsensor nach Anspruch 8, wobei die Strukturierungen wenigstens teilweise durch nichtleitendes Material aufgefüllt sind.

10. Hallsensor nach Anspruch 7, wobei die Stromführungsstruktur (112) durch in ein Halbleitersubstrat eindiffundierte Bereiche mit einer der Substratdotierung entgegengesetzten Dotierung gebildet ist.

11. Hallsensor nach einem der Ansprüche 7 bis 10, wobei die Stromführungsstruktur (112) dieselbe Rotationssymmetrie besitzt wie die Elektrodenpaare.

12. Hallsensor nach einem der vorhergehenden Ansprüche, wobei der Grundkörper (102) aus Silizium, Indiumarsenid, Indiumantimonid oder einem anderen Halbleitermaterial gefertigt ist.

13. Hallsensor nach Anspruch 12, wobei der Grundkörper (102) aus n-leitendem Silizium gefertigt ist.

14. Verfahren zum Messen eines räumlichen Magnetfeldes mittels eines dreidimensionalen Hallsensors nach einem der vorhergehenden Ansprüche, wobei das Messverfahren auf jedes der mindestens drei Paare von Elektrodenpaaren die folgenden Schritte anwendet:
(a) Einprägen eines ersten Speisestroms, der von dem ersten zum zweiten Anschluss eines der Elektrodenpaare fließt;
(b) Abgreifen einer ersten Hallspannung zwischen dem ersten und dem zweiten Anschluss des zweiten der Elektrodenpaare;
(c) Berechnen einer ersten Magnetfeldkomponente, die quer zu dem eingeprägten Speisestrom und quer zu einer Verbindungslinie zwischen dem ersten und dem zweiten Anschluss des zweiten der Elektrodenpaare verläuft, aus der gemessenen Hallspannung;
(d) Durchführen der Schritte (a) bis (c) mit nach einem Orthogonal-Switching-Prinzip oder einem Spinning-Current-Prinzip einfach oder mehrfach vertauschten Elektrodenpaaren, um geometrische, piezoresistive oder thermoelektrische Offsetkomponenten zu eliminieren;
wobei aus den mindestens drei bestimmten Magnetfeldkomponenten das räumliche Magnetfeld in einem gewünschten Koordinatensystem berechnet werden kann.

15. Verfahren nach Anspruch 14, das einen Hallsensor nach Anspruch 6 verwendet, so dass die drei bestimmten Magnetfeldkomponenten idealerweise senkrecht aufeinander stehen.

## Claims

1. Three-dimensional Hall sensor for detecting a spatial magnetic field, in which the Hall sensor (100) comprises an electrically conducting base body (102) and at least three electrode pairs (C₁, C_{1'}; ...C_{N}, C_{N'}),
wherein each electrode pair comprises a first terminal (C₁, ... C_{N}) and a second terminal (C_{1'} ... C_{N'}), which are arranged such on a base body (120) so as to allow a current flow through the base body (120) from the first to the second terminal,
wherein at least three first terminals are arranged on a first surface (104) of the base body and at least three second terminals are arranged on a second surface (106) of the base body different from the first surface, wherein the first surface and second surface oppose each other,
wherein at least three pairs of electrode pairs form at least three four-contact structures, each of which allows to measure one spatial component of the magnetic field using the Hall effect, wherein the directions of at least three measured components of the magnetic field span the three-dimensional space,
**characterized in that**
the first terminals (C₁, ... C_{N}) and the second terminals (C_{1'} ... C_{N'}) are arranged in a way that the terminals of each electrode pair (C₁, C_{1'}; ...C_{N}, C_{N'}) have a threefold rotational symmetry about an axis that is vertical towards the boundary surfaces.

2. Hall sensor according to claim 1, wherein different pairs of electrode pairs have among themselves common first terminals on the first surface and/or common second terminals on the second surface.

3. Hall sensor according to claim 1 or 2, wherein the first and the second surfaces are essentially arranged in parallel towards each other.

4. Hall sensors according to one of the preceding claims, wherein pairs of electrode pairs are arranged rotational symmetrically about an axis, which crosses the first and the second surfaces(104, 106).

5. Hall sensor according to claim 4, wherein the shape of the base body is symmetric and has at least the same rotational symmetry as the arrangement of the electrode pairs.

6. Hall sensor according to one of the preceding claims, wherein the at least three first terminals and the at least three second terminals are arranged such, that their respective interconnecting lines each form a triangle.

7. Hall sensor according to one of the preceding claims, wherein the at least three first terminals are at least partially surrounded by a current guiding structure (112) with an electrical conductivity lower than the material of the base body.

8. Hall sensor according to claim 7, wherein the current guiding structures (112) are manufactured as structuring, preferably grooves, trenches or cavities, integrated into the base body.

9. Hall sensor according to claim 8, wherein the structuring is at least partially filled with a non-conducting material.

10. Hall sensor according to claim 7, wherein the current guiding structures (112) are formed by areas diffused into the semiconductor substrate with a doping opposite to the doping of the substrate material.

11. Hall sensor according to claim 7 to 10, wherein the current guiding structures (112) have the same rotational symmetry as the electrode pairs.

12. Hall sensor according to one of the preceding claims, wherein the base body (102) is manufactured from silicon, indium arsenide, indium antimonide or another semiconductor material.

13. Hall sensor according to claim 12, wherein the base body is manufactured from n-conducting silicon.

14. Method for measuring the spatial magnetic field using a three-dimensional Hall sensor according to one of the preceding claims, wherein the measuring method applies to each of the three pairs of electrode pairs the following steps:
(a) Applying a first supply current, which flows from the first to the second terminal of the electrode pairs;
(b) Measuring a first Hall voltage between the first and the second terminal of the second electrode pairs;
(c) Calculating a first magnetic field component, which is perpendicular to the applied supply current and perpendicular to the connection line between the first and the second terminal of the second of the electrode pairs, from the measured Hall voltage;
(d) Carrying out the steps (a) to (c) following an Orthogonal-Switching-Principle or a Spinning-Current-Principle of single or repeated interchanges of the electrode pairs so as to eliminate the geometric, piezoresistive, or thermoelectric offset component;
wherein the spatial magnetic field can be evaluated in a desired coordinate system from the at least three determined magnetic field components.

15. Method according to claim 14, wherein a Hall sensor according to claim 6 is used, so that the three determined magnetic field components are ideally mutually orthogonal.

## Revendications

1. Capteur à effet Hall tridimensionnel destiné à détecter un champ magnétique spatial, dans lequel le capteur de Hall (100) comprend un corps de base (102) électriquement conducteur et au moins trois paires d'électrodes (C₁, C_{1'} ; ...C_{N}, C_{N'}),
dans lequel chacune des paires d'électrodes comporte une première connexion (C₁, ...C_{N}) et une deuxième connexion (C_{1'}, ...C_{N'}), qui sont agencées sur le corps de base (102) de façon à ce que puisse s'établir un flux de courant de la première à la deuxième connexion à travers le corps de base (102),
dans lequel au moins trois premières connexion sont agencées sur une première surface (104) du corps de base et au moins trois deuxièmes connexions sont agencées sur une deuxième surface (106) du corps de base, différente de la première, et la première et la deuxième surface étant mutuellement opposées,
et dans lequel au moins trois paires de paires d'électrodes forment au moins trois structures à quatre contacts, qui permettent respectivement la mesure d'une composante spatiale du champ magnétique par utilisation de l'effet Hall, les directions desdites au moins trois composantes mesurées du champ magnétique couvrant l'espace tridimensionnel,
**caractérisé en ce que** les premières connexions (C₁, ...C_{N}) et les deuxièmes connexions (C_{1'}, ...C_{N'}) sont agencées de manière telle, que les connexions de chaque paire d'électrodes (C₁, C_{1'} ; ...C_{N}, C_{N'}) présentent une symétrie de rotation d'ordre trois par rapport à un axe perpendiculaire aux surfaces de délimitation.

2. Capteur à effet Hall selon la revendication 1,
dans lequel différentes paires de paires d'électrodes présentent des premières connexions communes entre-elles sur la première surface, et/ou des deuxièmes connexions communes entre-elles sur la deuxième surface.

3. Capteur à effet Hall selon la revendication 1 ou la revendication 2, dans lequel la première surface et la deuxième surface sont agencées sensiblement de manière parallèle l'une à l'autre.

4. Capteur à effet Hall selon l'une des revendications précédentes, dans lequel les paires de paires d'électrodes sont agencées selon une symétrie de rotation autour d'un axe, qui traverse la première et la deuxième surface (104, 106).

5. Capteur à effet Hall selon la revendication 4,
dans lequel la forme du corps de base est symétrique et possède au moins la même symétrie de rotation que l'agencement des paires d'électrodes.

6. Capteur à effet Hall selon l'une des revendications précédentes, dans lequel lesdites au moins trois premières connexions et lesdites au moins trois deuxièmes connexions sont agencées de manière telle que leurs lignes de liaison forment ensemble respectivement un triangle.

7. Capteur à effet Hall selon l'une des revendications précédentes, dans lequel au moins les premières connexions sont entourées au moins partiellement par une structure de conduction de courant (112) de moindre conductibilité électrique que le matériau du corps de base.

8. Capteur à effet Hall selon la revendication 7,
dans lequel la structure de conduction de courant (112) est réalisée sous forme de structurations formées dans le corps de base, de préférence des fentes, des canaux ou des cavités.

9. Capteur à effet Hall selon la revendication 8,
dans lequel les structurations sont remplies au moins partiellement par un matériau non conducteur.

10. Capteur à effet Hall selon la revendication 7,
dans lequel la structure de conduction de courant (112) est formée par des zones diffusées dans un substrat semi-conducteur et présentant un dopage opposé au dopage du substrat.

11. Capteur à effet Hall selon l'une des revendications 7 à 10, dans lequel la structure de conduction de courant (112) possède la même symétrie de rotation que les paires d'électrodes.

12. Capteur à effet Hall selon l'une des revendications précédentes, dans lequel le corps de base (112) est fabriqué en silicium, en arséniure d'indium, en antimoniure d'indium ou en un autre matériau semi-conducteur.

13. Capteur à effet Hall selon la revendication 12,
dans lequel le corps de base (102) est fabriqué en silicium de type n-conducteur.

14. Procédé pour mesurer un champ magnétique spatial au moyen d'un capteur à effet Hall tridimensionnel selon l'une des revendications précédentes, le procédé de mesure utilisant sur chacune desdites au moins trois paires de paires d'électrodes, les étapes suivantes :
(a) application d'un premier courant d'alimentation, qui circule de la première à la deuxième connexion de l'une des paires d'électrodes ;
(b) prélèvement d'une première tension de Hall entre la première et la deuxième connexion de la deuxième des paires d'électrodes ;
(c) calcul, à partir de la tension de Hall mesurée, d'une première composante de champ magnétique, qui s'étend transversalement au courant d'alimentation appliqué et transversalement à une ligne de liaison entre la première et la deuxième connexion de la deuxième des paires d'électrodes ;
(d) exécution des étapes (a) à (c) avec des paires d'électrodes permutées de manière simple ou multiple selon un principe de commutation orthogonal ou un principe de courant tournant (spinning current), pour éliminer des composantes d'offset géométriques, piézo-résistives ou thermoélectriques ;
le champ magnétique spatial pouvant être calculé dans un système de coordonnées souhaité, à partir desdites au moins trois composantes de champ magnétique déterminées.

15. Procédé selon la revendication 14, qui utilise un capteur à effet Hall selon la revendication 6, de sorte que les trois composantes de champ magnétique déterminées sont idéalement perpendiculaires les unes aux autres.
